# EUROPÄISCHE PATENTSCHRIFT

(11) **EP 1 172 027 B1**
(45) Veröffentlichungstag und Bekanntmachung des Hinweises auf die Patenterteilung: **02.10.2002**
(21) Anmeldenummer: 00934855.8
(22) Anmeldetag: 03.04.2000
(51) Int. Cl.: H05K 9/00

(54) **SCHIRMEINRICHTUNG FÜR EINEN ELEKTRISCHEN BAUGRUPPENTRÄGER**
SHIELDING DEVICE FOR AN ELECTRICAL MODULE SUPPORT
DISPOSITIF DE BLINDAGE DESTINE A UN SUPPORT DE MODULE ELECTRIQUE

(30) Priorität: 16.04.1999 DE 19917382
(43) Veröffentlichungstag der Anmeldung: 16.01.2002
(73) Patentinhaber: SIEMENS AKTIENGESELLSCHAFT, 80333 München (DE)
(72) Erfinder: MAIR, Eduard, D-81477 München (DE)
(86) Internationale Anmeldenummer: DE0001016
(87) Internationale Veröffentlichungsnummer: WO00064230

(56) Entgegenhaltungen:
- EP-A- 0 351 070
- WO-A-92/16093
- AT-B- 364 441
- AT-B- 378 097

## Beschreibung

Die Erfindung bezieht sich auf eine Schirmeinrichtung für einen Baugruppenträger zur Aufnahme von einschiebbaren elektrischen Baugruppen, wobei zumindest eine Außenwand der Baueinheit ein gelochtes geerdetes Schirmblech zur elektromagnetischen Abschirmung und Entwärmung der Baueinheit aufweist.

Ein derartiger Baugruppenträger ist z.B. durch die WO 92/16093 bekannt geworden. Danach besteht ein Schirmgehäuse eines Baugruppenträgers aus Aluminiumblech, wobei die Oberund Unterseite zur Entwärmung des Baugruppenträgers als Lochbleche ausgebildet sind. Derartige Aluminiumbleche sind z.B. 2 mm dick und haben eine gute elektrische Leitfähigkeit. Durch die große Dicke des Schirmbleches ergeben sich auch bei einem hohen Lochanteil günstige Schirmbedingungen.

Ein Nachteil besteht darin, daß der Baugruppenträger nicht ausschließlich aus Aluminiumteilen gefertigt werden kann, so daß bei der Entsorgung die verschiedenen Materialien in aufwendiger Weise getrennt werden müssen.

Durch die EP 0351070 A ist ein Schirmgehäuse für eine elektrische Baugruppe bekannt geworden, bei der zwei gegenüberliegende Wände aus jeweils zwei Lochblechen gebildet sind, die zueinander versetzte Lüftungslöcher aufweisen, wodurch eine Schirmwirkung erzielt wird.

Der Erfindung liegt die Aufgabe zugrunde, die Kühlung der Baugruppen zu verbessern.

Diese Aufgabe wird durch die Erfindung gemäß Anspruch 1 gelost.

Der Isolator nach der Erfindung reduziert die Anzahl der Storkanten und verringert den Strömungswiderstand zwischen den beiden Schirmblechen erheblich, wodurch der Kühlluftdurchsatz erhöht, die Schirmwirkung aber nicht beeinträchtigt wird.

Die Lochplatte nach den Ansprüchen 2 und 3 läßt sich kostengunstig herstellen und einfach einsetzen.

Die Weiterbildung nach Anspruch 4 ergibt eine besonders stabile Außenwand, die bei hoher Steifigkeit eine Verringerung der Blechdicke ermöglicht.

Im Folgenden wird die Erfindung anhand eines in der Zeichnung dargestellten Ausführungsbeispieles näher erläutert.
- Figur 1: zeigt perspektivisch eine obere Außenwand eines Baugruppenträgers,
- Figur 2: einen Schnitt durch die Außenwand entlang der Linie II/II in Figur 1 mit einer Rückwandverdrahtungsplatte und einer einschiebbaren Baugruppe,
- Figur 3: einen Schnitt durch die Außenwand entlang der Linie III/III in Figur 1 mit einer Seitenwand des Baugruppenträgers.

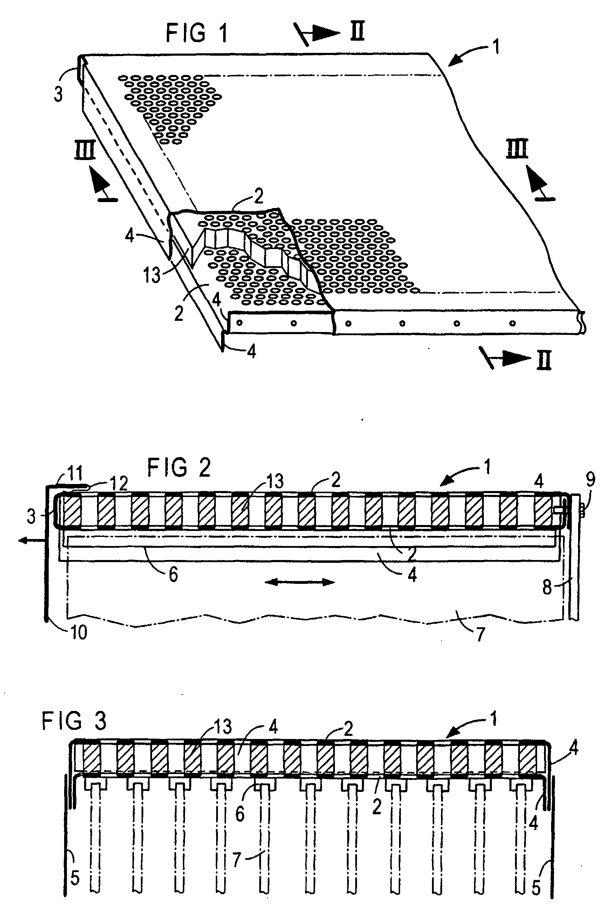

Nach den Figuren 1, 2 und 3 besteht eine obere Außenwand 1 eines Baugruppenträgers aus zwei mit Abstand übereinanderliegenden, zueinander parallelen gelochten Schirmblechen 2, die über einen frontseitigen Verbindungssteg 3 in zwei rechtwinkligen Biegungen einstückig miteinander verbunden sind. Die beiden Schirmbleche 2 weisen entlang ihrer übrigen Ränder rechtwinklig abgebogene Stege 4 auf, die sich jeweils über die gesamte Kantenlänge erstrecken und sich gegenseitig überlappen. Dabei sind die dem Verbindungssteg 3 gegenüberliegenden rückseitigen Stege 4 in entgegengesetzter Richtung gebogen, so daß der zum unteren Schirmblech 2 gehörende rückseitige Steg 4 nach außen abgebogen ist und den Einschubraum des Baugruppenträgers nicht beengt.

Die beiden übrigen Stegpaare 4 sind in die gleiche Richtung nach unten gebogen, wobei der zum oberen Schirmblech 2 gehörende seitliche Steg 4 um den Abstand zwischen den beiden Schirmblechen breiter ist, so daß es auch hier zu einer vollen Überlappung kommt. An diesen seitlichen Stegen 4 ist je eine Seitenwand 5 des Baugruppenträgers mittels nicht näher dargestellter Verbindungselemente befestigt.

An der Innenseite des unteren Schirmblechs 2 sind Führungen 6 für einschiebbare elektrische Baugruppen 7 lösbar befestigt, die von der Frontseite her in den Baugruppenträger einschiebbar sind. Auf der Unterseite des Baugruppenträgers befindet sich eine zweite nicht dargestellten Außenwand mit Führungen in spiegelsymmetrischer Anordnung. Auch diese Außenwand ist in gleicher Weise wie die obere Außenwand 1 mit den Seitenwänden 5 verbunden.

An den rückseitigen Stegen 4 der beiden Außenwände 1 ist eine Rückwandverdrahtungsplatte 8 mittels als Schrauben ausgebildeten Verbindungselementen 9 befestigt, die mit ihrem Gewinde in den der Rückwandverdrahtungsplatte 8 abgewandten rückseitigen Steg 4 eingreifen und damit die Rückwandverdrahtungsplatte 8 mit den rückseitigen Stegen 4 und diese untereinander verspannen. Die Rückwandverdrahtungsplatte 8 ist mit Schirmlagen versehen, die mit den rückseitigen Stegen 4 kontaktiert sind.

Die dem Verbindungssteg 3 zugewandte Frontseite des Baugruppenträgers ist durch eine Tür 10 verschlossen, die mit einem abgewinkelten Seitensteg 11 die Außenwand 1 umgreift. Am Seitensteg 11 ist ein gefiederter Dichtstreifen 12 befestigt, der am oberen Schirmblech 2 entlang dem Verbindungssteg 3 anliegt und beim Öffnen und Schließen der Tür 10 über die abgerundete Biegekante zwischen dem oberen Schirmblech 2 und dem Verbindungssteg 3 gleitet.

Der Zwischenraum zwischen den beiden Schirmblechen 2 ist durch eine isolierende Lochplatte 13 ausgefüllt. Die Lochmuster der beiden Schirmbleche 2 und der Lochplatte 13 sind deckungsgleich ausgebildet und fluchtend angeordnet, so daß bei jedem der einzelnen Löcher ein durchgehender Kanal gebildet ist, der geradlinig durch die beiden Schirmbleche 2 und das Lochblech 13 hindurchgeführt ist. Dadurch werden beim Durchtritt der Kühlluft Verwirbelungen vermieden, die ohne die Lochplatte 13 zwischen den beiden Schirmblechen 2 insbesondere an den inneren Lochkanten entstehen würden. Der Strömungswiderstand wird verringert und der Kühlluftdurchsatz erhöht, ohne das sich die Schirmwirkung verschlechtert.

## Patentansprüche

1. Schirmeinrichtung für einen Baugruppenträger zur Aufnahme von einschiebbaren elektrischen Baugruppen (7),
wobei zumindest eine Außenwand (1) des Baugruppenträgers zwei gelochte geerdete Schirmbleche (2) zur elektromagnetischen Schirmung und Entwärmung der Baueinheit aufweist und
wobei sich die Schirmbleche (2) mit Abstand zumindest annähernd parallel zueinander erstrecken,
**dadurch gekennzeichnet,**
**daß** die beiden Schirmbleche (2) und der Isolator miteinander deckungsgleiche, zueinander fluchtende Lochmuster aufweisen und daß der Zwischenraum zwischen den beiden Schirmblechen (2) mit einem Isolator (z.B. 13) ausgefüllt ist, an dem die beiden Schirmbleche (2) eng anliegen und dessen Lochmuster mit dem der Schirmbleche (2) deckungsgleich ist.

2. Schirmeinrichtung nach Anspruch 1,
**dadurch gekennzeichnet,**
**daß** der Isolator als flache Lochplatte (13) ausgebildet ist.

3. Schirmeinrichtung nach Anspruch 2,
**dadurch gekennzeichnet,**
**daß** die Lochplatte (13) aus Schaumstoff besteht, der vorzugsweise zumindest im Lochbereich eine laminierte Oberfläche aufweist.

4. Schirmeinrichtung nach Anspruch 3,
**dadurch gekennzeichnet,**
**daß** die beiden Schirmbleche (2) und die Lochplatte (13) als stoffschlüssig miteinander verbundenes Sandwich ausgebildet sind.

## Claims

1. Shielding device for a mounting rack for holding insertable electrical modules (7), at least one outer wall (1) of the mounting rack having one perforated, grounded shielding panel (2) for electromagnetically shielding and conducting away heat from the component, and the outer wall (1) having two of the perforated shielding panels (2) extending at least approximately parallel to one another and at a distance from one another, **characterized in that** the two shielding panels (2) and the insulator have perforation patterns which are congruent with one another and aligned with respect to one another, and **in that** the intermediate space between the two shielding panels (2) is filled with an insulator (for example 13) against which the two shielding panels (2) directly bear and whose perforation pattern is congruent with that of the shielding panels (2).

2. Shielding device according to Claim 1, **characterized in that** the insulator is embodied as a flat perforated panel (13).

3. Shielding device according to Claim 2, **characterized in that** the perforated panel (13) is composed of a foamed material which preferably has a laminated surface at least in the region of the perforations.

4. Shielding device according to Claim 3, **characterized in that** the two shielding panels (2) and the perforated panel (13) are embodied as a sandwich whose parts are connected to one another using a material.

## Revendications

1. Dispositif de blindage destiné à un support de module prévu pour recevoir des modules électriques enfichables (7),
au moins une paroi extérieure (1) du support de module comportant deux tôles de blindage (2) perforées et mises à la terre pour assurer le blindage électromagnétique et pour dissiper la chaleur de l'unité constructive et
les tôles de blindage (2), séparées par un intervalle, étant au moins approximativement parallèles entre elles,
**caractérisé par le fait**
**que** les deux tôles de blindage (2) et l'isolateur sont perforés selon un dessin identique, les perforations de chacun d'eux étant en alignement sur les autres, et
**que** l'espace entre les deux tôles de blindage (2) est occupé par un isolateur (par exemple, 13) sur lequel les deux tôles de blindage (2) sont étroitement accolées et dont le dessin des perforations est identique à celui des tôles de blindage (2).

2. Dispositif de blindage selon la revendication 1
**caractérisé par le fait**
**que** l'isolateur est conçu sous la forme d'une mince plaque perforée (13).

3. Dispositif de blindage selon la revendication 2
**caractérisé par le fait**
**que** la plaque perforée (13) est en mousse synthétique, laquelle a préférentiellement, au moins dans la zone perforée, une surface laminée.

4. Dispositif de blindage selon la revendication 3
**caractérisé par le fait**
**que** les deux tôles de blindage (2) et la plaque perforée (13) sont conçues comme panneau sandwich dont les matériaux sont en contact étroit.
